# EUROPÄISCHE PATENTANMELDUNG

(11) **EP 0 995 811 A2**
(43) Veröffentlichungstag der Anmeldung: **26.04.2000**
(21) Anmeldenummer: 99116587.9
(22) Anmeldetag: 25.08.1999
(51) Int. Cl.: C23C 14/16, C23C 16/30, C23C 16/40, B05D 3/00

(54) **Verfahren zum Aufbringen einer Schutzschicht**

(30) Priorität: 15.10.1998 DE 19847431
(71) Anmelder: Dr.Ing. h.c.F. Porsche Aktiengesellschaft, 70435 Stuttgart (DE)
(72) Erfinder: Separautzki, Reinhold, 71696 Möglingen (DE); Mucha, Andreas, 01728 Bannewitz (DE); Siegert, Lothar, 01809 Maxen (DE)

(57) **Zusammenfassung**

Damit eine in einer Vakuumkammer auf einem metallischen Grundkörper aufgebrachte Metallschicht bis zum Aufbringen einer Lackierung nicht oxidiert, wird in der Vakuumkammer eine eine Oxidbildung verhindernde Schutzschicht aufgebracht, welche vor dem Lackieren oder bei einer Deckbeschichtung in einer weiteren Vakuumkammer wieder entfernt werden kann.

## Beschreibung

Die Erfindung betrifft ein Verfahren zum Aufbringen einer Schutzschicht auf metallische Grundkörper, wie Fahrzeugteile, Fahrzeugräder und dergleichen, die metallisiert wurden und eine abschließende Lackbeschichtung oder dergleichen aufweisen.

Nach der Beschichtung von Fahrzeugteilen bzw. Rädern mit einer Metallschicht in einer Vakuumkammer, beispielsweise durch sogenanntes Sputtern, wird das Fahrzeugrad beispielsweise anschließend mit einer Lackbeschichtung oder dergleichen versehen.

Es ist bei mehrstufigen Produktionsprozessen nachteilig, wenn die bei Vakuumprozessen abgeschiedenen Metallschichten bei Luftkontakt oxidieren. Diese sich auf der Metalloberfläche bildenden sogenannten Luftoxide haben eine Reihe von Nachteile für nachfolgende Prozesse, wie beispielsweise bei Beschichtungen und/oder Lackierungsverfahren an der Luft oder bei weiteren Vakuumprozessen nach einem Luftkontakt.

Die Aufgabe der Erfindung besteht darin, ein Verfahren zur Aufbringung einer Schutzschicht auf Fahrzeugteile, insbesondere Fahrzeugräder zu schaffen, welche die Bildung einer Oxidschicht auf einer Metalloberfläche verhindert.

Diese Aufgabe wird erfindungsgemäß durch die Merkmale des Anspruchs 1 gelöst. Weitere vorteilhafte Merkmale beinhalten die Unteransprüche.

Die mit der Erfindung hauptsächlich erzielten Vorteile bestehen darin, daß innerhalb der Vakuumkammer, z.B. nach einem Sputterprozeß, eine Schutzschicht auf eine metallische Oberfläche aufgebracht wird, die bei Luftkontakt die Bildung einer Oxidschicht auf dieser Metallschicht verhindern soll.

Desweiteren kann diese Schutzschicht auch bei einer erneuten Beschichtung entfernt oder in den Beschichtungsprozeß mit einbezogen werden.

Die Entfernung der Schutzschicht erfolgt unter Vakuumbedingungen, so daß keine neue Oxidbildung erfolgt. Die Schutzschicht wird auf den mit einer Metallschicht versehenen Grundkörper, sei es ein Fahrzeugrad oder andere Fahrzeugteile, durch einen Vakuumprozeß, wie beispielsweise durch Plasmapolymerisation aufgebracht.

Die Schutzschicht besteht aus einer organischen oder anorganischen Verbindung und kann durch Polymerisation aus dieser Verbindung hergestellt werden.

Die Schutzschicht kann beispielsweise aus Si O₂, Ti-Oxyd usw. bestehen.

Bei einer Schutzschicht, die Silizium und organische Bestandteile enthält, hat das Silizium in der Verbindung die Aufgabe, eine haftfeste Verbindung der Schutzschicht zur metallischen Grundschicht auf dem Grundkörper zu sichern. Diese Grundschicht kann beispielsweise aus einer Chromschicht oder einer Titanschicht bestehen. Diese Schutzschicht weist auch eine definierte Härte auf.

Desweiteren ist es nach der Erfindung möglich, daß die Schutzschicht im Vakuum beispielsweise durch Plasmabehandlung bzw. durch Plasmadecompensation so entfernt wird, daß Silizium auf der Oberfläche verbleibt und beispielsweise mit der Chromschicht eine haftende Verbindung erzielt wird und diese als Haftvermittler für eine nachfolgende Beschichtung, z.B. Lackbeschichtung, dienen kann.

Das Verfahren zum Aufbringen einer Schutzschicht auf eine metallische Grundschicht, beispielsweise bei einem Rad, erfolgt in der Weise, daß die metallische Grundschicht in einer Vakuumkammer, beispielsweise durch einen Sputterprozeß, aufgebracht wird. Vor einem Lackieren oder einem sonstigen Auftrag kann diese Schutzschicht wieder in der Vakuumkammer entfernt werden und nachfolgend das Rad mit einer Lackierung versehen werden, so daß die metallische Grundschicht vor dem Lackieren keine Farbveränderung aufweist.

Auch kann die Oxidschutzschicht bis auf die Siliziumbestandteile in der Vakuumkammer entfernt werden, soweit dieser Bestandteil in der Schutzschicht vorhanden ist, so daß der Vorteil dieses Bestandteils als Haftvermittler für eine Endbeschichtung genutzt werden kann.

## Patentansprüche

1. Verfahren zum Aufbringen einer Schutzschicht auf metallische Grundkörper, wie Fahrzeugteile, Fahrzeugräder und dergleichen, die metallisiert wurden und eine abschließende Lackbeschichtung oder dergleichen aufweisen, dadurch gekennzeichnet, daß der metallische Grundkörper mit einer in einer Vakuumkammer erzeugten Metallschicht versehen wird und auf diese Metallschicht eine Schutzschicht im Vakuumverfahren aufgebracht wird und diese Schutzschicht wahlweise von der Metallschicht zur Aufbringung einer Lackbeschichtung entfernbar ist.

2. Verfahren nach Anspruch 1, dadurch gekennzeichnet, daß die Schutzschicht eine Dicke von 10 bis 20 nm aufweist.

3. Verfahren nach Anspruch 1, dadurch gekennzeichnet, daß die Schutzschicht durch Plasmapolymerisation aufgebracht wird.

4. Verfahren nach den Ansprüchen 1, 2 oder 3, dadurch gekennzeichnet, daß die Schutzschicht aus einer organischen oder anorganischen Verbindung hergestellt ist.

5. Verfahren zum Aufbringen einer Schutzschicht auf metallische Grundkörper, wie Fahrzeugteile, Fahrzeugräder und dergleichen, die metallisiert wurden und eine abschließende Lackbeschichtung oder dergleichen aufweisen, dadurch gekennzeichnet, daß die Schutzschicht als Bestandteil Silizium und organische Bestandteile enthält und beim Entfernen der Schutzschicht im Vakuumverfahren Silizium-Bestandteile auf der Metallschicht des Grundkörpers verbleiben und diese als Haftvermittler für eine nachfolgende Lackbeschichtung verwendet werden.

6. Verfahren nach einem oder mehreren der vorhergehenden Ansprüche, dadurch gekennzeichnet, daß die Schutzschicht aus Si O₂ besteht.

7. Verfahren nach einem oder mehreren der vorhergehenden Ansprüche, dadurch gekennzeichnet, daß die Schutzschicht aus Ti-Oxyd besteht.
